# EUROPÄISCHE PATENTSCHRIFT

(11) **EP 1 352 427 B1**
(45) Veröffentlichungstag und Bekanntmachung des Hinweises auf die Patenterteilung: **13.03.2013**
(21) Anmeldenummer: 02703491.7
(22) Anmeldetag: 16.01.2002
(51) Int. Cl.: H01L 25/07

(54) **SCHALTUNGSANORDNUNG MIT IN CHIPS ANGEORDNETEN HALBLEITERBAUELEMENTEN**
CIRCUIT ARRANGEMENT WITH SEMICONDUCTOR ELEMENTS ARRANGED IN CHIPS
CIRCUIT A COMPOSANTS SEMI-CONDUCTEURS AGENCES DANS DES PUCES

(30) Priorität: 19.01.2001 DE 10102359
(43) Veröffentlichungstag der Anmeldung: 15.10.2003
(73) Patentinhaber: Continental Automotive GmbH, 30165 Hannover (DE)
(72) Erfinder: GUNTER, Ludwig, 90592 Schwarzenbruck (DE); AUERSWALD, Gerd, 90616 Neuhof a.d. Zenn (DE)
(86) Internationale Anmeldenummer: PCT/DE2002/000105
(87) Internationale Veröffentlichungsnummer: WO 2002/058150

(56) Entgegenhaltungen:
- EP-A- 0 265 833
- EP-A- 0 697 732
- EP-A- 0 987 762
- EP-A- 1 028 465
- EP-A- 1 083 599
- DE-A- 10 008 582
- FR-A- 2 620 862
- US-A- 4 458 305
- US-A- 5 767 573

## Beschreibung

Die Erfindung betrifft eine Schaltungsanordnung mit in Chips angeordneten Halbleiterbauelementen, die z. B. für eine ISG-Elektronik (integrierter Startergenerator) in Kraftfahrzeugen geeignet ist.

Aus DE-G 92 03 000.9 U1 ist eine Schaltungsanordnung in Hybridtechnologie bekannt, bei der Chips mit Halbleiterbauelementen ohne Chipgehäuse direkt auf in einem Keramikträger angeordneten Leiterbahnen elektrisch kontaktiert und befestigt sind.

Nachteilig an einer solchen Schaltungsanordnung ist zum einen, dass sie aufgrund des Keramikträgers teuer ist. Zum anderen ist eine solche Schaltungsanordnung als Leistungsmodul für sehr hohe Ströme, wie z. B. 300 Ampere, nicht geeignet, da in einem Keramikträger angeordnete Leiterbahnen in der Regel solche hohen Ströme nicht leiten können.

Es ist eine Montageanordnung zur Parallelschaltung von MOS-Leistungstransistoren bekannt (FR 26 20 862 A), bei der mehrere Transistoren in einem Gehäuse angeordnet sind. Dieses Gehäuse weist eine isolierende, thermische leitfähige Platte auf, die auf einem metallischen Substrat angeordnet ist. Oberhalb dieser nichtleitenden Platte ist eine metallische Schicht angeordnet, auf der wiederum die Transistoren so angeordnet sind, dass jeweils ihr Drain-Anschluss mit dieser metallischen Schicht elektrisch in Verbindung steht.

Weiter ist eine Schaltunganordnung mit Leistungshalbleitern bekannt (EP 0 697 732 A2), die so aufgebaut ist, dass Leistungshalbleiterbauelemente entlang einer Seite einer rechteckigen Grundplatte angeordnet sind. Auf der Grundplatte ist eine keramische Isolatorplatte mit mehreren metallischen Elektrodenplatten angeordnet, wobei Leistungshalbleiterbauelemente so auf den Elektrodenplatten angeordnet sind, dass ihr Kollektoranschluss mit einer Elektrodenplatte elektrisch in Verbindung steht.

Der Erfindung liegt die Aufgabe zugrunde, eine Schaltungsanordnung mit in Chips angeordneten Halbleiterbauelementen anzugeben, die im Vergleich zum Stand der Technik sowohl kostengünstiger, als auch für sehr hohe Ströme geeignet ist.

Die Aufgabe wird gelöst durch eine Schaltungsanordnung gemäß dem Patentanspruch 1 mit in Chips angeordneten Halbleiterbauelementen und mit mindestens einem metallischen Körper zur elektrischen Kontaktierung der Halbleiterbauelemente und zur Spreizung und Ableitung von in den Halbleiterbauelementen erzeugte Wärme. Der oder die metallischen Körper sind derart ausgestaltet, dass er/sie zugleich als Träger der Halbleiterbauelemente dienen.

Die Chips sind an dem oder den Körpern befestigt.

Die Körper dienen also zugleich als Träger und als elektrische Leitungen. Die Chips werden mechanisch an den Körpern derart befestigt, dass sich eine elektrische Verbindung zwischen den Chips und den Körpern ergibt. Für den Träger der Chips wird auf teure Keramik verzichtet, wodurch die Schaltungsanordnung besonders kostengünstig sein kann.

Da die Körper keine in einem Substrat angeordnete Leiterbahnen sind, können sie einen großen Querschnitt aufweisen und damit hohe Ströme transportieren. Die Schaltungsanordnung ist folglich für sehr hohe Ströme geeignet.

Dies ist insbesondere dann der Fall, wenn die Halbleiterbauelemente mit dem oder den Körpern dadurch elektrisch verbunden sind, dass die Chips der Halbleiterbauelemente ohne Chipgehäuse direkt an dem oder den Körpern befestigt sind. Es sind keine weiteren Verbindungsleitungen zwischen den Körpern und den darauf angeordneten Halbleiterbauelementen, z.B. in Form von aus einem Chipgehäuse ragenden Pins, erforderlich, die die maximal mögliche Stromstärke begrenzen würden. Durch die direkte Anordnung der Chips auf den Körpern wird der elektrische Kontakt zwischen den Halbleiterbauelementen und den Körpern realisiert. Eine solche Schaltungsanordnung hat den zusätzlichen Vorteil, dass sie nur einen geringen Platzbedarf erfordert, da die Chips keine Chipgehäuse aufweisen.

Ein Chip eines Halbleiterbauelements, durch das starke Ströme fließen sollen, kann jedoch auch in einem Chipgehäuse angeordnet sein, dessen Rückseite durch eine metallische Platte gebildet wird, die direkt an dem Körper befestigt wird. Das Halbleiterbauelement ist auf der metallischen Platte des Chipgehäuses angeordnet.

Chips von Halbleiterbauelementen, durch die nur schwache Ströme fließen müssen, können auch in Gehäuse angeordnet sein, die z.B. durch Pins mit der oder den Körpern verbunden sind.

Neben dem für den Körper vorgesehen Anschluss eines Halbleiterbauelements sind andere Anschlüsse des Halbleiterbauelements vorgesehen, die durch Bondverbindungen kontaktiert werden.

Das Material des Körpers oder der Körper und das Material der Chips weisen vorzugsweise ähnliche thermische Ausdehnungskoeffizienten auf, damit zur Verringerung des Platzbedarfs der Schaltungsanordnung auf Chipgehäuse verzichtet werden kann, ohne dass Temperaturschwankungen zu mechanischen Verspannungen führen.

Sind die Chips direkt auf dem oder den Körpern angeordnet oder weisen die Chips Chipgehäuse auf, deren Rückseiten durch metallische Platten gebildet werden, wird die in den Halbleiterbauelementen erzeugte Wärme besonders gut abgeführt, da metallisches Material und damit die Körper eine hohe Wärmeleitfähigkeit und eine gute Wärmespreizung aufweisen.

Die Chips ohne Chipgehäuse oder mit Chipgehäuse, deren Rückseiten durch metallische Platten gebildet werden, sind jeweils an dem zugehörigen Körper z. B. durch Leitkleber oder Lot befestigt.

Eine Kühlvorrichtung ist zum Ableiten der in den Halbleiterbauelementen erzeugten Wärme eine Kühlvorrichtung vorgesehen. Die Körper sind auf der Kühlvorrichtung angeordnet. Dabei sind die Körper von der Kühlvorrichtung elektrisch isoliert. Die Isolation kann beispielsweise durch Anordnung z. B. einer handelsüblichen Wärmeleitfolie zwischen den Körpern und der Kühlvorrichtung realisiert werden.

Die Körper sind vorzugsweise so stabil ausgestaltet, dass sie auch vor dem Anordnen auf der Kühlvorrichtung nicht zerbrechen.

Die Kühlvorrichtung besteht beispielsweise aus einem metallischen gut wärmeleitenden Block, der mit Luft oder Wasser gekühlt wird.

Zur Leitung eines hohen Stroms sind vorzugsweise mehrere Halbleiterbauelemente mit demselben Ausgangsanschluss der Schaltungsanordnung verbunden. Der Ausgangsanschluss ist beispielsweise mit einem ersten metallischen Körper elektrisch verbunden. Auf dem ersten Körper sind erste der Halbleiterbauelemente mechanisch und leitend befestigt.

Die ersten Halbleiterbauelemente sind parallel geschaltet.

Die Schaltungsanordnung kann Leistungshalbleiterbauelemente und/oder normale elektronische Bauelemente aufweisen. Die Schaltungsanordnung ist ein Leistungsmodul,

Ein erster metallischer Sammelkörper ist als Anschluss für ein Ansteuermodul vorgesehen. Dabei sind Steueranschlüsse der ersten Halbleiterbauelemente mit Hilfe von Bonddrähten mit dem ersten Sammelkörper elektrisch verbunden. Zur Verbindung des Ansteuermoduls mit den ersten Halbleiterbauelementen reicht es aus, wenn eine einzige elektrische Verbindung zwischen dem Ansteuermodul und dem ersten metallischen Sammelkörper gelegt wird. Es ist nicht mehr erforderlich, das Ansteuermodul mit jedem der ersten Halbleiterbauelemente zu verbinden. Die Verbindung zwischen dem Ansteuermodul und dem Leistungsmodul gestaltet sich dadurch übersichtlich und einfach. Darüber hinaus ist die Funktionsfähigkeit des Leistungsmoduls unabhängig von der Anbindung zu einem Ansteuermodul prüfbar, da eine Prüfvorrichtung die ersten Halbleiterbauelemente steuern kann, indem sie mit dem ersten Sammelkörper verbunden wird. Andernfalls wäre eine unübersichtliche Anzahl an Halbleiterbauelementen mit der Prüfvorrichtung zu verbinden. Auch vereinfacht sich eine Reparatur einer Anordnung bestehend aus einem Leistungsmodul und einem damit verbundenen Ansteuermodul, da bei einem Fehler im Ansteuermodul dieses durch Lösen der Verbindung zum ersten Sammelkörper leicht vom Leistungsmodul getrennt, repariert oder ausgewechselt werden kann. Ein erneutes Bonden der vielen Chips zur Verbindung mit einem reparierten Ansteuermodul ist nicht erforderlich. Darüber hinaus können die parallel geschalteten ersten Halbleiterbauelemente mit einer hohen Stromstärke angesteuert werden, da der Sammelkörper einen wesentlich größeren Querschnitt aufweisen kann als elektrische Leitungen auf einer Leiterplatte. Eine Ansteuerung mit einer hohen Stromstärke ist z.B. für Stresstests vorteilhaft, um Schwachstellen des Leistungsmoduls aufzuspüren. Die Herstellung des ersten Sammelkörpers kann gleichzeitig mit der Herstellung der Körper erfolgen.

Das Leistungsmodul kann z. B. einen weiteren Ausgangsanschluss aufweisen. Der weitere Ausgangsanschluss ist elektrisch verbunden mit dem zweiten metallischen Körper. Die Halbleiterbauelemente umfassen zweite Halbleiterbauelemente, die parallel geschaltet sind und an dem zweiten Körper befestigt sind. Es ist ein zweiter metallischer Sammelkörper als Anschluss für das Ansteuermodul vorgesehen. Steueranschlüsse der zweiten Halbleiterbauelemente sind mit Hilfe von Bonddrähten mit dem zweiten Sammelkörper verbunden.

Als Groundanschluss ist einen dritten metallischen Sammelkörper vorgesehen. Anschlüsse der Halbleiterbauelemente können mit Hilfe von Bonddrähten mit den dritten Sammelkörpern verbunden werden. Die ersten Halbleiterbauelemente sind mit dem dritten Sammelkörper verbunden.

Als Material für die Körper bzw. die Sammelkörper eignet sich insbesondere Kupfer. Aber auch andere Metalle oder Legierungen können verwendet werden. Die Körper oder Sammelkörper können auch aus Schichten verschiedener Metalle bestehen. Die Körper können beispielsweise auch im wesentlichen aus Kupfer bestehen sowie einer metallischen Oxidationsschutzschicht aus z.B. Nickel.

Die ersten bis dritten Sammelkörper bestehen im wesentlichen aus Kupfer.

Die Körper oder die Sammelkörper können die Form von Schienen aufweisen. Alternativ kann ein Körper oder Sammelkörper die Form einer Platte oder strukturierten Platte aufweisen.

Die Körper bzw. Sammelkörper können z.B. aus einem Blech gestanzt, gesägt oder erodiert werden. Auch ein Schneideverfahren mit Hilfe eines Lasers ist möglich.

Um gleich zu Beginn des Herstellungsverfahrens der Schaltungsanordnung eine feste relative Anordnung der Körper bzw. Sammelkörper zu erhalten, ist es vorteilhaft, alle Körper und Sammelkörper aus demselben Blech zu erzeugen und dabei dünne Stege zwischen den Körpern bzw. Sammelkörpern zu belassen. Nach dem Anordnen z.B. auf der Kühlvorrichtung, können die Stege entfernt werden. Alternativ können die fertiggestellten Körper bzw. Sammelkörper mit Hilfe von Kunststoffspritzguss durch Kunststoffstege miteinander verbunden werden, die für die fertige Schaltungsanordnung nicht wieder entfernt werden müssen.

Im Folgenden wird ein Ausführungsbeispiel der Erfindung anhand der Figuren näher erläutert.
- Figur 1: zeigt eine dreidimensionale Darstellung eines Leistungsmoduls mit einem ersten Körper, einem zweiten Körper, einem ersten Sammelkörper, einem zweiten Sammelkörper, einem dritten Sammelkörper, ersten Leistungshalbleiterbauelementen, zweiten Leistungshalbleiterbauelementen, einer Kühlvorrichtung und Bonddrähten. Das Leistungsmodul ist über elektrische Leitungen mit einem Ansteuermodul verbunden.
- Figur 2: zeigt ein Schaltbild des Leistungsmoduls.

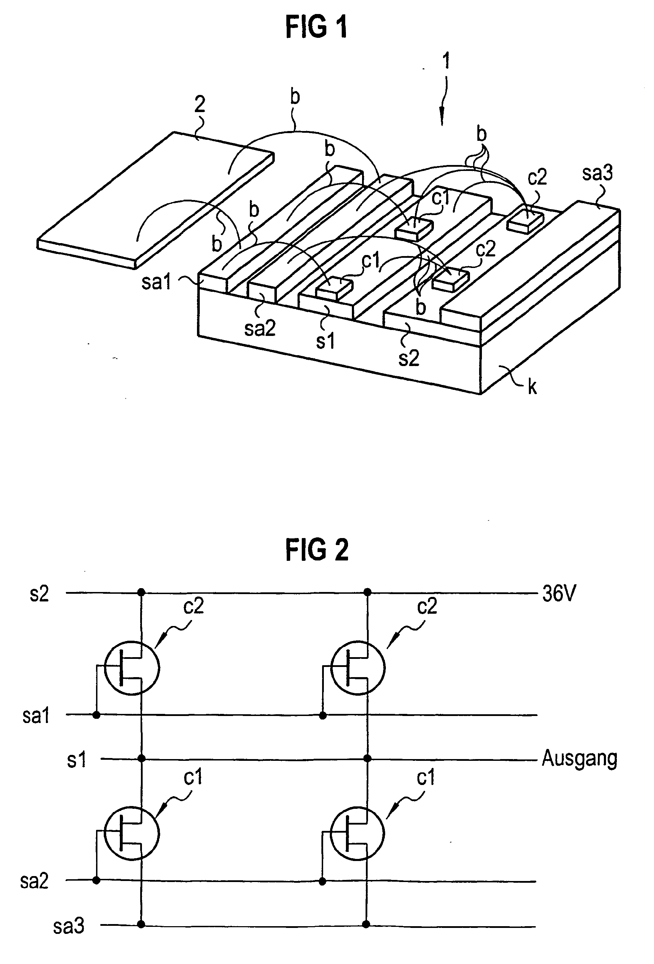

Im Ausführungsbeispiel ist ein Leistungsmodul 1 vorgesehen, das in Chips c angeordnete Leistungshalbleiterbauelemente aufweist. Die Leistungshalbleiterbauelemente umfassen erste Leistungshalbleiterbauelemente und zweite Leistungshalbleiterbauelemente (siehe Figur 1).

Die ersten Leistungshalbleiterbauelemente sind parallel geschaltet. Die nackten Chips c1 der ersten Leistungshalbleiterbauelemente sind mit Hilfe eines Leitklebers an einem als Schiene ausgestalteten ersten Körper s1 aus Kupfer befestigt. Dadurch sind die ersten Leistungshalbleiterbauelemente elektrisch mit dem ersten Körper s1 verbunden. An dem ersten Körper s1 ist ein Ausgangsanschluss des Leistungsmoduls 1 angeordnet.

Die zweiten Leistungshalbleiterbauelemente sind parallel zueinander geschaltet. Die nackten Chips c2 der zweiten Leistungshalbleiterbauelemente sind auf einer als Schiene ausgestaltenden zweiten Körper s2 aus Kupfer mit Hilfe eines Leitklebers befestigt. Dadurch sind die zweiten Leistungshalbleiterbauelemente mit dem zweiten Körper s2 elektrisch verbunden. An dem zweiten Körper s2 ist ein Anschluss des Leistungsmoduls 1 angeordnet, der konstant auf ca. 36 Volt gehalten wird.

Der erste Körper s1 und der zweite Körper s2 sind nebeneinander angeordnet, ca. 8mm breit und ca. 2mm hoch.

Neben dem ersten Körper s1 sind ein erster als Schiene ausgestalteter Sammelkörper sa1 und ein zweiter als Schiene ausgestalteter Sammelkörper sa2 aus Kupfer angeordnet. Steueranschlüsse der ersten Leistungshalbleiterbauelemente werden mit Hilfe von Bonddrähten b mit dem ersten Sammelkörper sa1 verbunden. Steueranschlüsse der zweiten Leistungshalbleiterbauelemente werden mit Hilfe von Bonddrähten mit dem zweiten Sammelkörper sa2 verbunden. Der erste Sammelkörper sa1 und der zweite Sammelkörper sa2 dienen dem Anschluss des Leistungsmoduls 1 an ein Ansteuermodul 2.

Über dem zweiten Körper s2 ist elektrisch isoliert von dem zweiten Körper s2 ein als Schiene ausgestalteter dritter Sammelkörper sa3 aus Kupfer angeordnet. Der dritte Sammelkörper sa3 dient dem Anschluss an ein Groundpotential. Anschlüsse der ersten Leistungshalbleiterbauelemente und der zweiten Leistungshalbleiterbauelemente sind mit Hilfe von Bonddrähten b mit dem dritten Sammelkörper sa3 verbunden.

Die ersten Leistungshalbleiterbauelemente arbeiten als Lowsidedriver. Die zweiten Leistungshalbleiterbauelemente arbeiten als Highsidedriver. Jeweils ein Paar bestehend aus einem ersten Leistungshalbleiterbauelement und einem zweiten Leistungshalbleiterbauelement bilden eine Gegentaktendstufe (siehe Figur 2).

Der erste Sammelkörper sa1, der zweite Sammelkörper sa2, der erste Körper s1 und der zweite Körper s2 sind auf einer Kühlvorrichtung k angeordnet. Die Kühlvorrichtung k besteht aus einem metallischen Block und wird durch Luft oder Wasser gekühlt. Zur elektrischen Isolation der Kühlvorrichtung k von den Sammelkörpern sa1, sa2 und den Körpern s1, s2 ist zwischen der Kühlvorrichtung und den Sammelkörpern sa1, sa2 bzw. den Körpern s1, s2 eine isolierende Wärmeleitfolie angeordnet (nicht dargestellt).

## Patentansprüche

1. Schaltungsanordnung mit in Chips angeordneten Halbleiterbauelementen, die als Leistungsmodul (1) ausgebildet ist,
- mit mindestens zwei metallischen, im wesentlichen aus Kupfer bestehenden Körpern (s1, s2) zur elektrischen Kontaktierung der Halbleiterbauelemente und zur Ableitung von in den Halbleiterbauelementen erzeugte Wärme,
- bei der zum Ableiten der in den Halbleiterbauelementen erzeugten Wärme die Körper (s1, s2) auf einer von den Körpern (s1, s2) elektrisch isolierten Kühlvorrichtung (k) nebeneinander angeordnet ist,
- wobei die metallischen Körper (s1, s2) derart ausgestaltet sind, dass sie zugleich als Träger der Halbleiterbauelemente dienen,
- wobei die Chips (cl, c2) an den metallischen Körpern (s1, s2) befestigt sind,
- bei der die Halbleiterbauelemente erste Halbleiterbauelemente umfassen, die parallel geschaltet sind,
- bei der die Körper einen ersten Körper (s1) umfassen, an dem die Chips (c1) der ersten Halbleiterbauelemente befestigt sind,
- bei der die Halbleiterbauelemente zweite Halbleiterbauelemente umfassen, die parallel geschaltet sind,
- bei der die Körper einen zweiten Körper (s2) umfassen, an dem die Chips (c2) der zweiten Halbleiterbauelemente befestigt sind,
- bei der ein dritter metallischer, im wesentlichen aus Kupfer bestehender Sammelkörper (sa3) als Ground-anschluss vorgesehen ist, der auf dem zweiten Körper (s2) elektrisch isoliert angeordnet ist,
- bei der Anschlüsse der ersten Halbleiterbauelemente mit Hilfe von Bonddrähten (b) mit dem dritten Sammelkörper (sa3) verbunden sind,
- bei der mindestens ein erster metallischer, im wesentlichen aus Kupfer bestehender Sammelkörper (sa1) als Anschluss für ein Ansteuermodul (2) vorgesehen ist,
- bei der Steueranschlüsse der ersten Halbleiterbauelemente mit Hilfe von Bonddrähten (b) mit dem ersten Sammelkörper (sa1) elektrisch verbunden sind,
- bei der ein zweiter metallischer, im wesentlichen aus Kupfer bestehender Sammelkörper (sa2) als Anschluss für das Ansteuermodul (2) vorgesehen ist,
- bei der Steueranschlüsse der zweiten Halbleiterbauelemente mit Hilfe von Bonddrähten (b) mit dem zweiten Sammelkörper (sa2) elektrisch verbunden sind,
- wobei der erste und der zweite metallische Sammelkörper (sa1, sa2) neben dem ersten und dem zweiten metallischen Körper (s1, s2) auf der Kühlvorrichtung (k) angeordnet sind.

2. Schaltungsanordnung nach Anspruch 1,
- bei der die Halbleiterbauelemente mit den Körpern (s1, s2) dadurch elektrisch verbunden sind, dass die Chips (cl, c2) der Halbleiterbauelemente ohne Chipgehäuse direkt an den Körpern (s1, s2) befestigt sind.

3. Schaltungsanordnung nach Anspruch 1 oder 2,
- bei der die Chips (cl, c2) der Halbleiterbauelemente jeweils an dem zugehörigen Körper (s1, s2) durch Leitkleber oder Lot befestigt sind.

## Claims

1. Circuit arrangement which comprises semiconductor components arranged in chips and which is embodied as a power module (1),
- having at least two metallic bodies (sl, s2) substantially made of copper for the purpose of electrically contacting the semiconductor components and for dissipating heat generated in the semiconductor components,
- in which, in order to dissipate the heat generated in the semiconductor components, the bodies (sl, s2) are arranged adjacent to one another on a cooling device (k) which is electrically insulated from the bodies (sl, s2),
- wherein the metallic bodies (sl, s2) are embodied in such a way that they simultaneously serve as carriers for the semiconductor components,
- wherein the chips (c1, c2) are fixedly mounted on the metallic bodies (sl, s2),
- in which the semiconductor components comprise first semiconductor components which are connected in parallel,
- in which the bodies comprise a first body (s1) on which the chips (c1) of the first semiconductor components are fixedly mounted,
- in which the semiconductor components comprise second semiconductor components which are connected in parallel,
- in which the bodies comprise a second body (s2) on which the chips (c2) of the second semiconductor components are fixedly mounted,
- in which a third metallic collector body (sa3) substantially made of copper is provided as a ground terminal which is arranged in an electrically insulated manner on the second body (s2),
- in which terminals of the first semiconductor components are connected to the third collector body (sa3) with the aid of bond wires (b),
- in which at least one first metallic collector body (sa1) substantially made of copper is provided as a terminal for a control module (2),
- in which control terminals of the first semiconductor components are electrically connected to the first collector body (sa1) with the aid of bond wires (b),
- in which a second metallic collector body (sa2) substantially made of copper is provided as a terminal for the control module (2),
- in which control terminals of the second semiconductor components are electrically connected to the second collector body (sa2) with the aid of bond wires (b),
- wherein the first and the second metallic collector body (sal, sa2) are arranged adjacent to the first and the second metallic body (sal, sa2) on the cooling device (k).

2. Circuit arrangement according to claim 1,
- in which the semiconductor components are electrically connected to the bodies (sl, s2) in such a way that the chips (c1, c2) of the semiconductor components are fixedly mounted without a chip package directly on the bodies (sl, s2).

3. Circuit arrangement according to claim 1 or 2,
- in which the chips (c1, c2) of the semiconductor components are in each case fixedly mounted on the associated body (s1, s2) by means of conductive adhesive or solder.

## Revendications

1. Agencement de circuit avec des composants semi-conducteurs agencés en puces, conçu comme un module de puissance (1),
- avec au moins deux corps (s1, s2) métalliques constitués principalement de cuivre, assurant le contact électrique des composants semi-conducteurs et permettant la dissipation de la chaleur produite dans les composants semi-conducteurs,
- dans lequel, pour la dissipation de la chaleur produite dans les composants semi-conducteurs, les corps (s1, s2) sont agencés les uns à côté des autres sur un dispositif de refroidissement (k) isolé électriquement par rapport aux corps (s1, s2),
- les corps métalliques (s1, s2) étant ainsi arrangés qu'ils servent en même temps de supports pour les composants semi-conducteurs,
- les puces (cl, c2) étant fixées contre les corps métalliques (s1, s2),
- dans lequel les composants semi-conducteurs comprennent des premiers composants semi-conducteurs branchés en parallèle,
- dans lequel les corps comprennent un premier corps (s1) contre lequel les puces (c1) des premiers composants semi-conducteurs sont fixées,
- dans lequel les composants semi-conducteurs comprennent des deuxièmes composants semi-conducteurs branchés en parallèle,
- dans lequel les corps comprennent un deuxième corps (s2) contre lequel les puces (c2) des deuxièmes composants semi-conducteurs sont fixées,
- dans lequel un troisième corps collecteur (sa3) métallique constitué principalement de cuivre est prévu en tant que branchement à la terre, qui est agencé sur le deuxième corps (s2) de manière électriquement isolée,
- dans lequel les branchements des premiers composants semi-conducteurs sont reliés au troisième corps collecteur (sa3) à l'aide de fils de connexion (b),
- dans lequel au moins un premier corps collecteur (sa1) métallique constitué principalement de cuivre est prévu en tant que branchement pour un module de pilotage (2),
- dans lequel les branchements de commande des premiers composants semi-conducteurs sont électriquement reliés au premier corps collecteur (sa1) à l'aide de fils de connexion (b),
- dans lequel un deuxième corps collecteur (sa2) métallique constitué principalement de cuivre est prévu en tant que branchement pour le module de pilotage (2),
- dans lequel les branchements de commande des deuxièmes composants semi-conducteurs sont électriquement reliés au deuxième corps collecteur (sa2) à l'aide de fils de connexion (b),
- le premier et le deuxième corps collecteurs métalliques (sal, sa2) étant agencés sur le dispositif de refroidissement (k) à côté du premier et du deuxième corps métalliques (s1, s2).

2. Agencement de circuit selon la revendication 1,
- dans lequel les composants semi-conducteurs sont reliés électriquement aux corps (s1, s2) du fait que les puces (cl, c2) des composants semi-conducteurs sont fixées sans boîtiers de puces directement contre les corps (s1, s2).

3. Agencement de circuit selon la revendication 1 ou 2,
- dans lequel les puces (cl, c2) des composants semi-conducteurs sont respectivement fixées au corps (s1, s2) correspondant par de la colle conductrice ou par brasage.
